# EUROPEAN PATENT APPLICATION

(11) **EP 2 672 538 A1**
(43) Date of publication of application: **11.12.2013**
(21) Application number: 12742495.0
(22) Date of filing: 31.01.2012
(51) Int. Cl.: H01L 41/113, H01L 41/18, H02N 2/00

(54) **POWER GENERATING DEVICE AND POWER GENERATING MODULE USING SAME**

(30) Priority: 01.02.2011 JP 2011020168
(71) Applicant: Panasonic Corporation, Osaka 571-8501 (JP)
(72) Inventor: YAMAUCHI, Norihiro, Osaka 540-6207 (JP); OGAWA, Junya, Osaka 540-6207 (JP); GOTO, Kouji, Osaka 540-6207 (JP); MATSUSHIMA, Tomoaki, Osaka 540-6207 (JP); AIZAWA, Koichi, Osaka 540-6207 (JP)
(74) Representative: Appelt, Christian W.
(86) International application number: PCT/JP2012/052050
(87) International publication number: WO 2012/105522

(57) **Abstract**

Providing a power generating device that can output higher power as well as downsize the device, and providing a power generating module using the same. The power generating device **1** has a power generating section **20** that includes a piezoelectric body **21;** and a plurality of electrode pairs each constituted by a pair of electrodes **(22, 23)** that are placed on opposite sides of the piezoelectric body **21** with regard to a thickness direction thereof to define a functional section **21a** therebetween, each of the functional sections **21a** is cooperated with the related electrode pair **(22, 23)** to define a power generating element **200.** A plurality of the power generating elements **200** includes a first power generating element **201** and a second power generating element **202** configured to give a polarization orientation opposite to each other in the thickness direction. The first and second power generating elements **(201, 202)** are configured to have the corresponding electrodes **(22, 22)** that are connected to each other by means of a wiring member **24** on the same surface of the piezoelectric body **21** with regard to the thickness direction thereof, such that all of the plurality of the power generating elements **200** are connected in series.

## Description

### TECHNICAL FIELD

The invention relates to a power generating device and a power generating module using same.

### BACKGROUND ART

It has been known a power generating device (piezoelectric-type vibration power generating device) that employs a piezoelectric body and is configured to convert a vibration energy into an electric energy. The devices have been interested, for example, in an Energy Harvesting field, and have been studied by various researchers (e.g. see R. van Schaijk, et al, "Piezoelectric AIN energy harvesters for wireless autonomous body solutions", IEEE SENSORS 2008 Conference, 2008, p.45-48 (hereinafter referred to as "non-patent document 1 "), S. Roundy and P. K. Wright, "A piezoelectric vibration based generator for wireless electronics", Smart Materials and Structures 13, 2004, p.1131-1142 (hereinafter referred to as "non-patent document 2") or the like). The non-patent document 1 describes to utilize PZT (Pb(Zr,Ti)O₃) as a material of the piezoelectric body. The non-patent document 2 describes to utilize PZT and aluminum nitride (AIN) as a material of the piezoelectric body.

In general, the power generating devices can be classified by the morphology of the piezoelectric body (into thin film type or bulk type). The non-patent document 1 describes a thin film type power generating device produced by micromachining technology. The non-patent document 2 describes a bulk type power generating device.

The power generating device disclosed in the non-patent document 1 includes a device substrate **301** formed of a silicon substrate **300** (see Fig. 23). The device substrate **301** includes: a supporting section **311** having a rectangular frame shape; a cantilever section (beam) **312** arranged on the inside of the supporting section **311** and swingably supported to the supporting section **311;** and a weight section **313** formed at an end of the cantilever section **312.** The power generating device further includes a power generating section **320** that is formed on the cantilever section **312** of the device substrate **301** and that is configured to generate an AC voltage in response to a swing movement of the cantilever section **312.**

The power generating section **320** includes: a lower electrode **322;** a piezoelectric film **321** formed on the opposite side of the cantilever section **312** from the lower electrode **322;** and an upper electrode **323** formed on the opposite side of the lower electrode **322** through the piezoelectric film **321.** In short, the lower electrode **322** is formed on the cantilever section **312,** the piezoelectric film **321** is formed on the lower electrode **322,** and the upper electrode **323** is formed on the piezoelectric film **321.** In the power generating section **320,** the lower electrode **322** is formed of a Pt film, the piezoelectric film **321** is formed of an AIN thin film or a PZT thin film, and the upper electrode **323** is formed of an Al film.

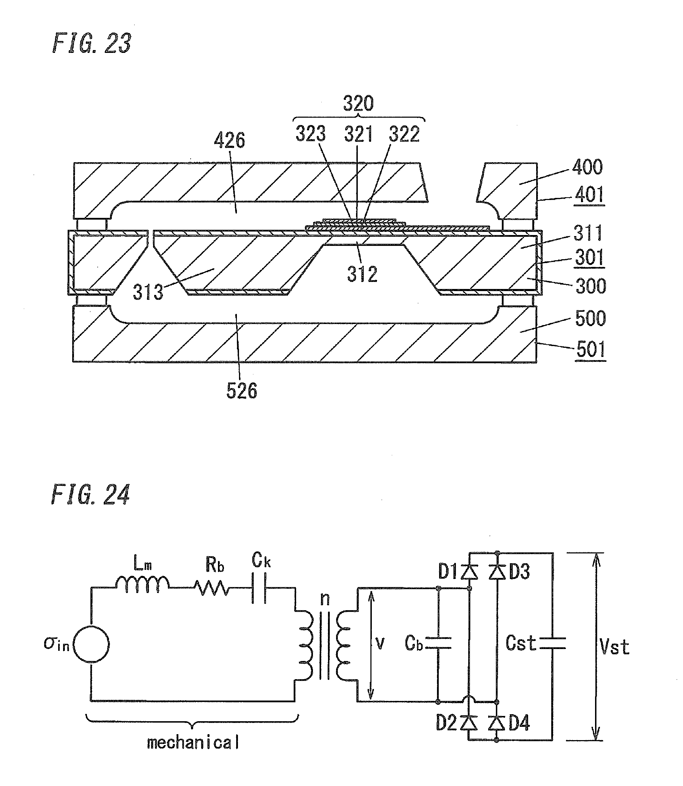

The power generating device further includes: a first cover substrate **401** that is formed of a first glass substrate **400** and is fixed to the supporting section **311** at a first surface side (upper side in Fig. 23) of the device substrate **301;** and a second cover substrate **501** that is formed of a second glass substrate **500** and is fixed to the supporting section **311** at a second surface side (lower side in Fig. 23) of the device substrate **301.**

Note that, the cantilever section **312** and the weight section **313** define a moving section of the device substrate **301.** In the power generating device, displacement spaces **(426, 526)** for the moving section are formed between the first cover substrate **401** and the moving portion and the second cover substrate **501** and the moving section, respectively.

The power generating device disclosed in the non-patent document 2 includes a supporting section, a cantilever section swingably supported to the supporting section, and a weight section provided at one end of the cantilever section away from the other end supported to the supporting section. The cantilever section is formed of a bimorph cell that is composed of two piezoelectric layers pasted each other.

The non-patent document 2 further discloses a diagram of Fig. 24 as an equivalent circuit model of a power generating system including the power generating device.

The equivalent circuit model expresses an equivalent circuit of the power generating device using: an equivalent inductance **L**ₘ that represents a mass or an inertia weight of the weight section; an equivalent resistor **R**_{b} that represents a mechanical dumping; an equivalent capacitor **C**ₖ that represents a mechanical stiffness; an equivalent stress σ **ᵢₙ** generated depending on an application of an external vibration; an equivalent winding ratio **n** of a transformer; and a capacitor **C**_{b} composed of a power generating section. The equivalent circuit model includes: a full-wave rectifier that includes four diodes **(D1, D2, D3, D4)** connected to form a bridge circuit and is configured to full-wave rectify an output voltage **v** of the power generating device; and an electricity storage capacitor **Cst** that is connected between output terminals of the full-wave rectifier.

Compared with the bulk type power generating device exemplified in the non-patent document 2, the thin film type power generating device, such as the power generating device describe in the non-patent document 1, has an inferior output voltage although can be downsized. Therefore, the thin film type power generating device has been desired to increase the output voltage. In case of constructing a power generating module that can output DC voltage using the power generating device described in the non-patent document 1, it may be possible to adopt the configuration exemplified in the non-patent document 2 in which output terminals of the power generating device are connected by a full-wave rectifier. In this case also, it is demanded to increase the output voltage.

### DISCLOSURE OF INVENTION

The present invention is developed in view of above reason, and the objective of the present invention is to provide a power generating device that can output higher power as well as downsize the device and to provide a power generating module using the power generating device.

The power generating device of the present invention comprises: a device substrate having a supporting section, a cantilever section swingably supported to said supporting section, and a weight section provided at one end of said cantilever section away from the other end supported to said supporting section; and a power generating section carried by said cantilever section and configured to generate an AC voltage in response to a swing movement of said cantilever section, wherein said power generating section comprises: a piezoelectric body; and a plurality of electrode pairs each constituted by a pair of electrodes that are placed on opposite sides of said piezoelectric body with regard to a thickness direction of said piezoelectric body to define a functional section therebetween, each of the functional sections being cooperated with the related electrode pair to define a power generating element; wherein a plurality of the power generating elements comprises a first power generating element and a second power generating element configured to give a polarization orientation opposite to each other in the thickness direction, and wherein said first and second power generating elements are configured to have the corresponding electrodes being connected to each other by means of a wiring member on the same surface of said piezoelectric body with regard to the thickness direction thereof, such that all of said plurality of the power generating elements are connected in series.

In this power generating device, it is preferred that wherein one electrode, which is formed on said piezoelectric body after forming said piezoelectric body, of the electrode pair is made of a sheet electrode.

In this power generating device, it is preferred that wherein said cantilever section has embedding holes that are buried to form a part of the respective functional sections of the power generating elements, and wherein the piezoelectric body is formed of a self planarization film.

In this power generating device, it is preferred that wherein all of said plurality of the power generating elements are connected in series such that said first and second power generating elements are connected alternately.

In this power generating device, it is preferred that wherein said corresponding electrodes of said first and second power generating elements connected to each other by means of said wiring member are formed on the same surface side in the thickness direction.

In this power generating device, it is preferred that wherein the functional sections of said plurality of the power generating elements are formed in a single piezoelectric body.

The power generating module of the present invention comprises: said power generating device as set forth in any one claims of 1 to 6; and a circuit board on which said power generating device is mounted, wherein said circuit board is provided with a full-wave voltage doubler for a voltage doubler rectification of the voltage output from said power generation device.

The power generating device of the present invention can output higher power as well as downsize the device

The power generating module of the present invention can output higher power as well as downsize the device

### BRIEF DESCRIPTION OF DRAWINGS

Preferred embodiments of the invention will now be described in further details. Other features and advantages of the present invention will become better understood with regard to the following detailed description and accompanying drawings where:
Fig. 1 shows a power generating device according to a first embodiment, Fig. 1A is a schematic planar view thereof, Fig. 1B is a sectional view thereof taken along A-A' line of Fig. 1A, and Fig. 1C is a sectional view thereof taken along B-B' line of Fig. 1A;
Fig. 2 includes Figs. 2A to 2C, and Figs. 2A to 2C are explanatory views for illustrating a production method of the power generating device according to the first embodiment;
Fig. 3 includes Figs. 3A to 3C, and Figs. 3A to C are explanatory views for illustrating the production method of the power generating device according to the first embodiment;
Fig. 4 includes Figs. 4A and 4B, and Figs. 4A and 4B are explanatory views for illustrating the production method of the power generating device according to the first embodiment;
Fig. 5 shows a power generating device according to a first reference aspect, Fig. 5A is a schematic planar view thereof, and Fig. 5B is a sectional view thereof taken along A-A' line of Fig. 5A;
Fig. 6 is a waveform diagram showing an output voltage of the power generating device according to the first reference aspect;
Fig. 7 shows an equivalent circuit model of the power generating device according to the first reference aspect;
Fig. 8 is an illustration view showing a simulation result of wave form of open circuit voltage output from the power generating device according to the first reference aspect;
Fig. 9 shows an equivalent circuit model of the power generating device according to the first embodiment;
Fig. 10 is an illustration view showing a simulation result of wave form of open circuit voltage output from the power generating device according to the first embodiment;
Fig. 11 is a schematic planar view of a power generating module according to the first embodiment;
Fig. 12 shows an equivalent circuit model of the power generating module according to the first embodiment;
Fig. 13 is an illustration view showing a simulation result of charge characteristics of the power generating device according to the first embodiment;
Fig. 14 is a circuit diagram of a power generating module according to a second reference aspect;
Fig. 15 shows an equivalent circuit model of the power generating module according to the second reference aspect;
Fig. 16 is an illustration view showing a simulation result of charge characteristics of the power generating module according to the second reference aspect;
Fig. 17 shows an equivalent circuit model of a power generating module according to a third reference aspect;
Fig. 18 is an illustration view showing a simulation result of charge characteristics of the power generating module according to the third reference aspect;
Fig. 19 is a schematic exploded perspective view of a power generating device according to a second embodiment;
Fig. 20 is a sectional view of main part of a first cover substrate included in the power generating device according to the second embodiment;
Fig. 21 is a schematic planar view of a power generating device according to a third embodiment;
Fig. 22 shows the power generating device according to the third embodiment, and is a schematic sectional view thereof taken along A-A' line of Fig. 21;
Fig. 23 is a schematic sectional view of a conventional power generating device; and
Fig. 24 shows an equivalent circuit model according to another conventional power generating device.

### BEST MODE FOR CARRYING OUT THE INVENTION

### (First Embodiment)

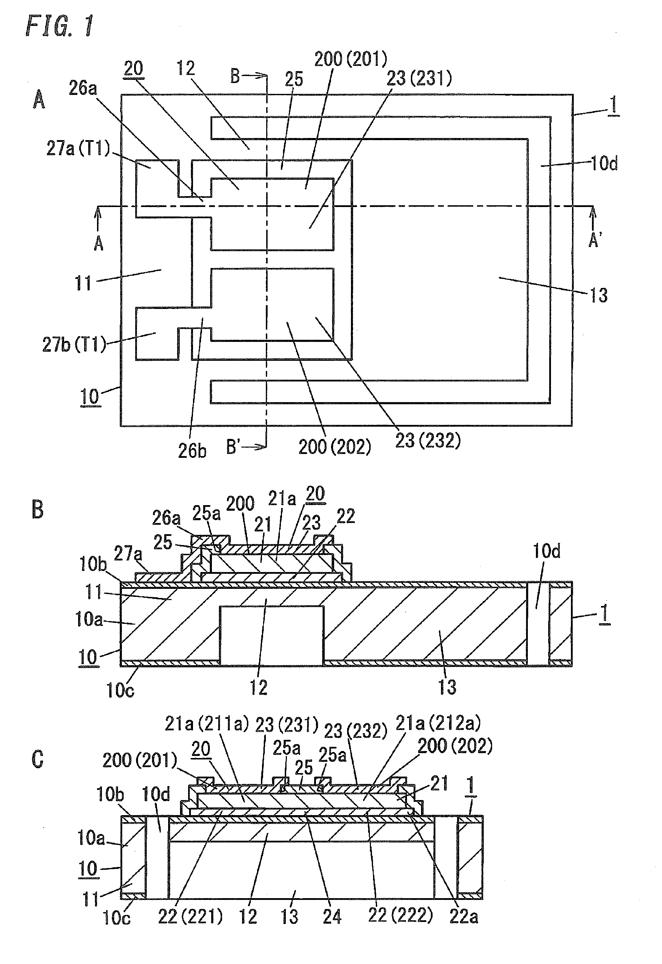

A power generating device according to the present embodiment is described below with reference to Fig. 1.

The power generating device **1** includes: a device substrate **10** having a supporting section **11,** a cantilever section **12** swingably supported to the supporting section **11,** and a weight section **13** provided at one end of the cantilever section **12** away from the other end supported to the supporting section **11.** The cantilever section **12** carries a power generating section **20** configured to generate an AC voltage in response to a swing movement of the cantilever section **12.**

The device substrate **10** is formed of a substrate **10a**. In the present embodiment, the substrate **10a** is a single-crystalline silicon substrate having a (100) surface as a first surface. Note that, the substrate **10a** is not limited thereto, and may be a polycrystalline silicon substrate. A first insulation film **10b** is formed on the first surface of the substrate **10a**. The first insulation film **10b** is made of a silicon dioxide film. The power generating section **20** is formed on the first insulation film **10b.** The substrate **10a** and the power generating section **20** are therefore electrically insulated by the first insulation film **10b** of the silicon dioxide film formed at a first surface side of the substrate **10a**. A second insulation film **10c** is formed on a second surface (a surface opposite to the first surface) of the substrate **10a**. The second insulation film **10c** is made of a silicon dioxide film. Note that, the second insulation film **10c** can be omitted. The substrate **10a** is not limited to a silicon substrate, and may be a SOI (Silicon on Insulator) substrate, an MgO (magnesium oxide) substrate, a metal substrate, a glass substrate, a polymer substrate or the like. In a case where the substrate **10a** is an insulating substrate such as an MgO substrate, a glass substrate, or a polymer substrate, the first insulation film **10b** can be omitted.

In the device substrate **10a**, the supporting section **11** is formed into a frame shape (rectangular frame shape in this embodiment). The cantilever section **12** and the weight section **13** are located on the inside of the supporting section **11.** The cantilever section **12** has a smaller thickness (thickness in the top-bottom direction in Fig. 1B) than that of the weight section **13.** Combination of the cantilever section **12** and the weight section **13** defines a movable section (that can move relative to the supporting section **11)** of the device substrate **10.** The device substrate **10** is formed with a slit **10d** having a U-shape in planar view and surrounding the movable section (composed of the cantilever section **12** and the weight section **13),** whereby the movable section is spatially divided from the supporting section **11** other than a portion where the cantilever section **12** is connected to the supporting section **11.** In other words, as shown in Fig. 1A, the cantilever section **12** is formed into a rectangular shape in planar view, and is connected to the supporting section **11** only at one side (left side in Fig. 1A) thereof. The weight section **13** is spatially divided from the supporting section **11.** With this configuration, the movable section (the cantilever section **12** and the weight section **13)** is swingably supported by the supporting section **11.** The supporting section **11** is not limited to a frame shape, as long as it can swingably support the cantilever section **12.**

The power generating section **20** is formed at a first surface side (top side in Fig. 1 B) of the device substrate **10.** The power generating section **20** is formed on the first surface of the device substrate **10.** The power generating section **20** includes a plurality (two in this embodiment) of power generating elements **200,** and each of the plurality of power generating elements **200** is defined by: a pair of electrodes **(22, 23)** placed on opposite sides of a piezoelectric body **21** with regard to a thickness direction (top-bottom direction in Figs. 1B, 1C) of the piezoelectric body **21;** and a functional section **21a** that is defined as a part of the piezoelectric body **21** between the related pair of electrodes **(22, 23).** That is, the power generating section **20** includes: the piezoelectric body **21;** and a plurality of electrode pairs each constituted by a pair of electrodes **(22, 23)** that are placed on opposite sides of the piezoelectric body **21** with regard to the thickness direction of the piezoelectric body **21** to define the functional section **21a** therebetween, and each of the functional sections **21a** is cooperated with the related electrode pair **(22, 23)** to define the power generating element **200.** In other words, each of the plurality of power generating elements **200** is defined by: an electrode **22** of lower side that is one of the pair of electrodes **(22, 23);** the functional section **21a** defined as a part of the piezoelectric body **21;** and an electrode **23** of upper side that is the other of the pair of electrodes **(22, 23).** The electrode **22** is formed on the device substrate **10.** The functional section **21a** is formed on the electrode **22.** The electrode **23** is formed on the functional section **21a**. The power generating element **200** of the present embodiment is formed into a rectangular shape when viewed in the thickness direction (in the front-back direction in Fig. 1A) of the piezoelectric body **21.** The plurality of power generating elements **200** includes a first power generating element **201** and a second power generating element **202** configured to give a polarization orientation opposite to each other in the thickness direction of the piezoelectric body **21.** That is, the plurality (two in this embodiment) of power generating elements **200** includes one or more (one in this embodiment) of the first power generation elements **201** and one or more (one in this embodiment) of the second power generating elements **202.** The first and second power generating elements **(201, 202)** are configured to give a polarization orientation opposite to each other in the thickness direction of the piezoelectric body **21.** In Fig. 1C, the power generating element **201** illustrated in the left side in the figure has a polarization orientation of upward direction, and the power generating element **202** illustrated in the right side in the figure has a polarization orientation of downward direction. That is, in the embodiment in Fig. 1C, a polarization orientation of a functional section **211 a** of the left side power generating element **201** faces upward, and a polarization orientation of a functional section **212a** of the right side power generating element **202** faces downward. A capacitor constituted by the first power generating element **201** therefore has a polarity in which the upper-side electrode **23(231)** is positive and the lower-side electrode **22(221)** is negative. A capacitor constituted by the second power generating element **202** has a polarity in which the lower-side electrode **22(222)** is positive and the upper-side electrode **23(232)** is negative.

In the power generating section **20,** the first and second power generating elements **(201, 202)** are configured to have the corresponding electrodes **(22, 22)** being connected to each other by means of a wiring member **24** on the same surface of the piezoelectric body **21** with regard to the thickness direction thereof, such that all of the plurality of power generating elements **200** are connected in series. That is, in the power generating section **20,** the corresponding electrodes of the first and second power generating elements **(201, 202)** connected to each other by means of the wiring member are formed on the same surface in the thickness direction of the piezoelectric body **21.** The corresponding electrodes are connected to each other on the surface of the piezoelectric body where these electrodes are formed. The plurality of the power generating elements **200** are connected in series such that the first power generating element **201** and the second power generating element **202** are connected alternately.

In the power generating section **20,** each power generating element **200** is composed of a piezoelectric transducer having the electrode **22** (hereinafter, it may be referred to as lower electrode **22),** the functional section **21a**, and the electrode **23** (hereinafter, it may be referred to as upper electrode 23). When the cantilever section **12** swings, the piezoelectric body **21** (the functional section **21a**) receives a stress in response to the swing movement to generate a charge bias in the upper electrode **23** and the lower electrode **22,** and an AC voltage is generated at the power generating element **200.** In short, the power generating device **1** of the present embodiment is a piezoelectric type vibration power generating device which is configured to generate an electric power by utilizing piezoelectric effect of a piezoelectric material. Each of the power generating elements **200** is connected to another power generating element **200** in a manner that the electrodes of opposite polarity are connected. As a result, the power generating section **20** generates an output voltage obtained by summing the AC voltages generated by the individual power generating elements **200.**

The lower electrode **221** of the first power generating element **201,** the wiring member **24** and the lower electrode **222** of the second power generating element **202** are continuously connected. A first metal layer **22a**, which is constituted by the lower electrode **221** of the first power generating element **201**, the wiring member **24,** and the lower electrode **222** of the second power generating element **202,** has a rectangular shape in planar view. Each of the upper electrode **231** of the first power generating element **201** and the upper electrode **232** of the second power generating element **202** has a rectangular planar shape the planar size of which is slightly smaller than that of an object defined by dividing equally the first metal layer **22a** by a line extending along a longitudinal direction of the cantilever section **12.** The upper electrode **231** of the first power generating element **201** and the upper electrode **232** of the second power generating element **202** are formed so as to be divided from each other in a width direction (right-left direction in Fig. 1C) of the cantilever section **12.** The piezoelectric body **21** has a rectangular planar shape the planar size of which is slightly smaller than that of the first metal layer **22a** as well as is slightly larger than that of an object defined by the two upper electrodes **(23, 23)** and a part (a part lying between the upper electrodes **(23, 23))** of an insulation layer **25.**

In the present embodiment, the piezoelectric body **21** is made of PZT (Pb(Zr,Ti)O₃), but the piezoelectric material of the piezoelectric body **21** is not limited thereto. For example, PZT-PMN (Pb(Mn,Nb)O₃) or PZT doped with another impurities can be used for the piezoelectric material. AIN, ZnO, KNN (K_{0.5}Na_{0.5}NbO₃), KN (KNbO₃), NN (NaNbO₃), KNN doped with impurities (such as Li, Nb, Ta, Sb, Cu) also can be used for the piezoelectric material. In the present embodiment, all of the functional sections **21a** of the plurality of power generating elements **200** are formed in a single piezoelectric body **21.** In other words, the single piezoelectric body **21** includes the functional sections **21a** of the plurality of power generating elements **200.** With this configuration, all the plurality of power generating elements **200** have a substantially identical characteristic. As a result, it can produce a homogeneous device.

The lower electrode **22** is made of PT, but the material of the lower electrode **22** is not limited thereto. For example, Au, Al, Ir, or the like can be used. The upper electrode **23** is made of Au, but the material of the upper electrode **23** is not limited thereto. For example, Mo, Al, Pt, Ir, or the like can be used.

In the power generating device **1** of the present embodiment, the lower electrode **22** has a thickness of 500 [nm], the piezoelectric body **21** has a thickness of 600 [nm], and the upper electrode **23** has a thickness of 100 [nm], but these thickness are not limited thereto. Note that, it is possible that the piezoelectric body **21** is formed with a pinhole during a producing process thereof. In order to overcome a disadvantage, it is preferred that the upper electrode **23** that is formed after forming the piezoelectric body **21** is set to have a smaller thickness than that of the piezoelectric body **21.** That is, in a case where the piezoelectric body **21** has a pinhole, there is a concern that the electrode material of the upper electrode **23** may deposit in the inside of the pinhole during a forming process of the upper electrode **23** through sputtering method on the piezoelectric body **21.** Even in such a case, this configuration enables to prevent a short between the upper electrode **23** formed on the piezoelectric body **21** and the lower electrode **22** formed under the piezoelectric body **21.** As a result, this configuration can improve the production yield and therefore can save the cost, and can improve the reliability of the product.

The upper electrode **23** is not limited to those produced by patterning (by way of a photolithographic technique and an etching technique) a thin film that is formed through a thin-film formation technique (such as sputtering method, chemical vapor deposition (CVD) method or evaporation method). For example, the upper electrode **23,** which is formed on the piezoelectric body **21,** may be made of a sheet electrode (or an electrode sheet). This configuration can solve the problem that the electrode material is deposited in the pinhole when the upper electrode **23** is formed on the piezoelectric body **21.** This configuration therefore is enabled to reliably prevent a short between the upper electrode **23** formed on the piezoelectric body **21** and the lower electrode formed under the piezoelectric body **21.**

The upper electrode **23** of the sheet electrode is formed on the piezoelectric body **21** preferably through vacuum laminating method. The sheet electrode is preferably formed of a laminate sheet with coating the electrode material through sputtering method etc or a metal foil such as an aluminum foil.

The power generating device **1** is preferably provided with a buffer layer between the device substrate **10** and the lower electrode **22.** The buffer layer is made of a proper material in consideration of the piezoelectric material of the piezoelectric body **21.** For example, it is preferred to use SrRuO₃, (Pb,La)TiO₃, PbTiO₃, MgO, LaNiO₃ or the like for the material of the buffer layer in a case where PZT is used as the piezoelectric material of the piezoelectric body **21.** The buffer layer may be formed of a laminate of a Pt film and a SrRuO₃ film. Providing the buffer layer improves a crystallinity of the piezoelectric body **21.**

A first pad **27a** and a second pad **27b** are formed at the first surface side of the device substrate **10.** The first pad **27a** is electrically connected through a first metal wiring **26a** to an electrode **231** (shown at upper side in Fig. 1A, and left side in Fig. 1 C) that is an electrode located at one end of a series circuit composed of all the power generating elements **200,** and the second pad **27b** is electrically connected through a second metal wiring **26b** to an electrode **232** (shown at lower side in Fig. 1A, and right side in Fig. 1C) that is an electrode located at the other end of the series circuit. Each of the pads (**27a**, **27b)** is formed on the supporting section **11** of the device substrate **10** (formed at a position corresponding to the supporting section **11** of the device substrate **10).** The first pad **27a** and the second pad **27b** constitute respective output terminals (**T1**, **T1**).

Each of the metal wirings (**26a**, **26b)** and the pads (**27a**, **27b)** is made of Au, but the material thereof is not limited thereto. For example, Mo, Al, Pt, Ir or the like can be used. In the present embodiment, all of the metal wirings (**26a**, **26b),** the pads (**27a**, **27b)** and the upper electrodes **23** are made of an identical material. In addition, the metal wirings **(26a, 26b),** the pads (**27a**, **27b)** and the upper electrodes **23** are all formed simultaneously. This configuration therefore can simplify the production process and can save the cost, compared with a case where one of the metal wirings (**26a**, **26b),** the pads (**27a**, **27b)** or the upper electrodes **23** is made of different material from other components.

The insulation layer **25** is formed at the first surface side of the device substrate **10.** The insulation layer **25** has openings **(25a, 25a**) for determining contact areas between the respective upper electrodes **(23, 23)** and the piezoelectric body **21.** The insulation layer **25** extends to reach the first surface of the device substrate **10** (reach the first insulation film **10b).** The insulation layer **25** is formed so as to cover over an entire lateral surface of the first metal layer **22a** and an entire lateral surface of the piezoelectric body **21.** This configuration enables to prevent a short between the first metal layer **22a** and the first metal wiring **26a** as well as prevent a short between the first metal layer **22a** and the second metal wiring **26b.** In the present embodiment, the insulation layer **25** is made of a silicon dioxide film, but is not limited to a silicon dioxide film. For example, the insulation layer **25** may be made of a silicon nitride film.

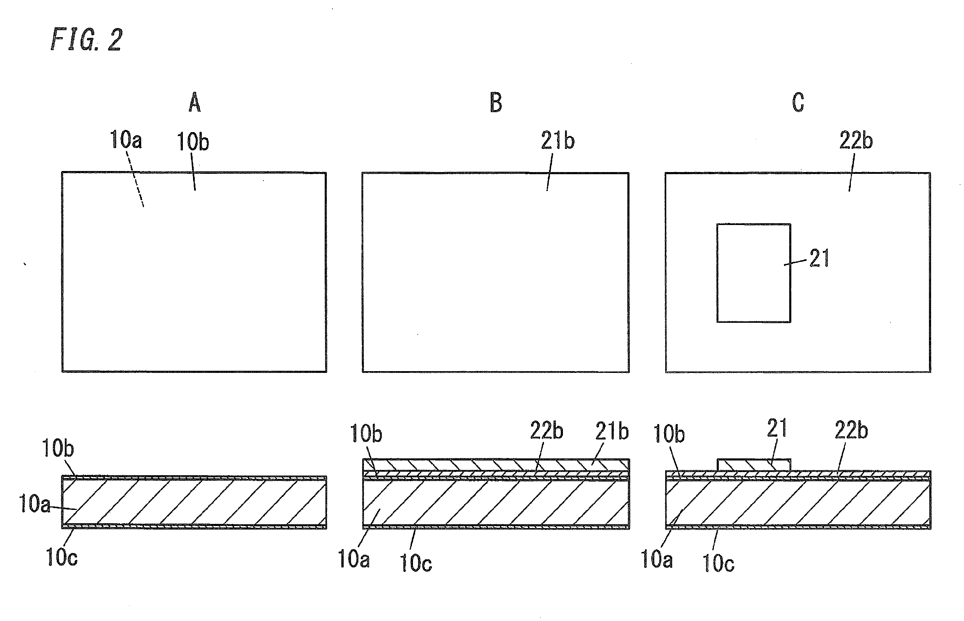

A method of producing the power generating device 1 of the present embodiment is explained below with reference to Figs. 2 to 4. Each of Figs. 2 to 4 includes two pictures, and the upper one is a schematic planar view and the lower one is a schematic sectional view.

An insulation film forming process is first performed by forming insulation films **(10b, 10c)** of silicon films at first and second surface sides of the substrate **10a**, respectively. As a result, structure shown in Fig. 2A is obtained. In the insulation film forming process, the insulation films **(10b, 10c)** are preferably formed through thermal oxidation method, CVD method or the like.

A metal film forming process is then performed by forming a metal film **22b** over an entire surface of the first surface side of the substrate **10a**. Note that, the metal film **22b** serves as a basis of a first metal layer **22a** composed of a wiring member **24** and each lower electrode **(22, 22).** A piezoelectric film forming process is then performed by forming a piezoelectric film (such as a PZT thin film) **21 b** over an entire surface of the first surface side of the substrate **10a**. Note that, the piezoelectric film **21** b serves as a basis of a piezoelectric body **21.** As a result, structure shown in Fig. 2B is obtained. In the metal film forming process, the metal film **22b** is formed through sputtering method, but the forming method is not limited thereto. For example, the metal film **22b** can be formed through CVD method, evaporation method, or the like. In the piezoelectric film forming process, the piezoelectric film **21 b** is formed through sputtering method, but the forming method is not limited thereto. For example, the piezoelectric film **21 b** can be formed through CVD method, sol-gel method, or the like.

A piezoelectric film patterning process is then performed by patterning the piezoelectric film **21 b** to form the piezoelectric body **21** that is formed of a part of the piezoelectric film **21 b.** As a result, structure shown in Fig. 2C is obtained. In the piezoelectric film forming process, the piezoelectric film **21 b** is patterned by photolithographic technique and etching technique.

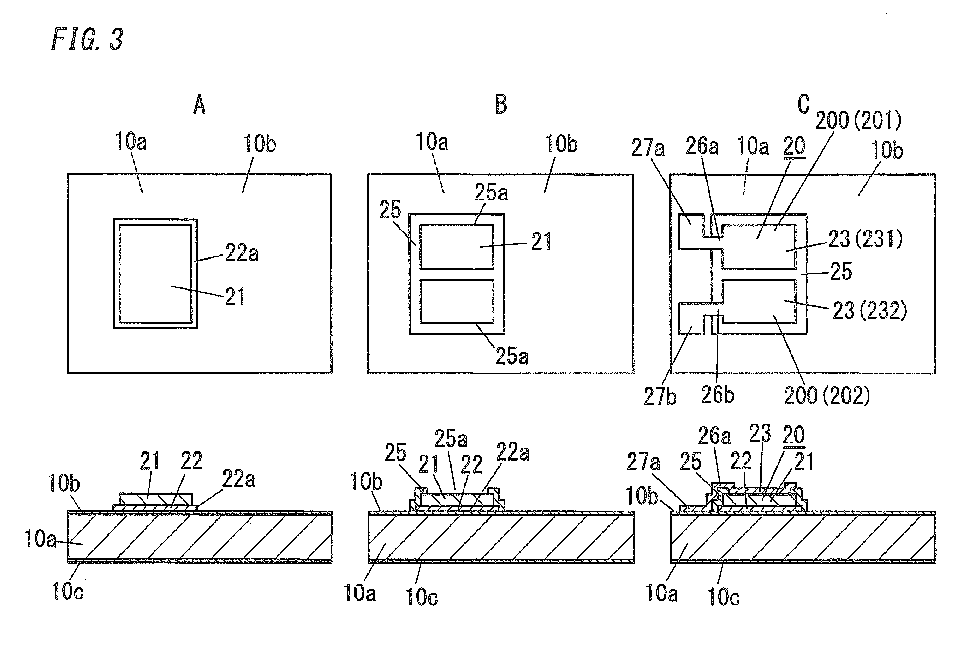

A metal film patterning process is then performed by patterning the metal film **22b** to form the first metal layer **22a** (the wiring member **24** and each of the lower electrodes **22)** that is formed of a part of the metal film **22b.** As a result, structure shown in Fig. 3A is obtained. In the metal film patterning process, the metal film **22b** is patterned by photolithographic technique and etching technique. Because the present embodiment includes a single first power generating element **201** and a single second power generating element **202,** just one first metal layer **22a** is formed in this process. In a case where there needs a plurality of first power generating element **201** and/or a plurality of second power generating element **202,** a plurality of first metal layers **22a** can be formed.

An insulation layer forming process is then performed by forming an insulation layer **25** at the first surface side of the substrate **10a**. As a result, structure shown in Fig. 3B is obtained. In the insulation layer forming process, the insulation layer **25** is formed over an entire surface of the first surface side of the substrate **10a** through CVD method or the like, and then the insulation layer **25** is patterned through photolithography technique and etching technique to form openings **(25a, 25a**). In the insulation layer forming process, the insulation layer **25** having the openings **(25a, 25a**) may be formed through liftoff method.

An upper electrode forming process for forming upper electrodes **(23(231), 23(232))** and a wiring forming process for forming metal wirings (**26a**, 26b) and pads (**27a**, **27b)** are then performed simultaneously. As a result, structure shown in Fig. 3C is obtained. In the upper electrode forming process, the upper electrodes **(23, 23)** are formed through thin-film formation technique of such as sputtering method or CVD method, photolithographic technique, and etching technique. In the wiring forming process, the meal wirings (**26a**, **26b)** and the pads (**27a**, **27b)** are formed through thin-film formation technique of such as sputtering method or CVD method, photolithographic technique, and etching technique.

A polarization treatment process is then performed for polarizing (poling treatment) a part of the piezoelectric body **21** located between the electrodes **(22, 23)** by applying electricity between the pads (**27a**, **27b).** Functional sections (**21a**(**211a**), **21a**(**212a**)) of the respective first and second power generating elements **(201, 202)** are formed by performing the polarization treatment process.

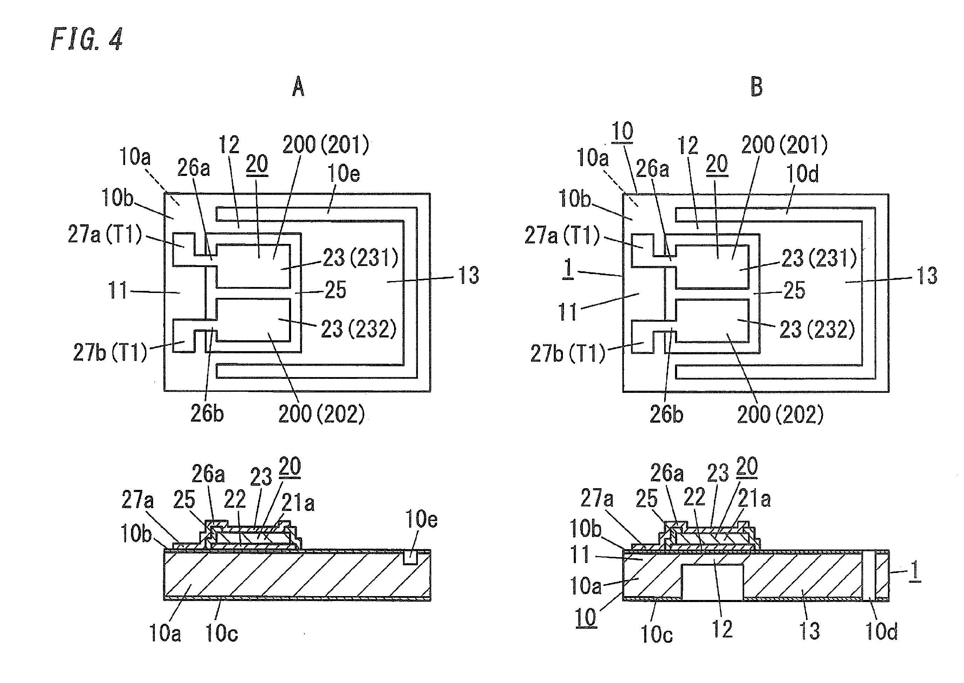

A groove forming process for forming a groove **10e** is then performed by etching the substrate **10a** from the first surface side to remove a part of the substrate **10a** other than the cantilever section **12,** the weight section **13** and the supporting section **11** (i.e. remove a part of the substrate **10a** that corresponds to above mentioned slit **10d)** so that the etching depth reaches the thickness of the cantilever section **12.** As a result, structure shown in Fig. 4A is obtained. In the groove forming process, the groove **10e** is formed through such as photolithography technique and etching technique.

A cantilever section forming process is then performed for forming the cantilever section **12** as well as the weight section **13** and the supporting section **11** by etching the substrate **10a** from a second surface side to remove a part of the substrate **10a** other than the weight section **13** and the supporting section **11** (i.e. remove a part of the substrate **10a** corresponding to the slit **10d** and the cantilever section **12).** As a result, a power generating device **1** having structure shown in Fig. 4B is obtained. In the cantilever section forming process, the cantilever section **12,** the weight section **13** and the supporting section **11** are formed through such as photolithography technique and etching technique. The slit **10d** is formed by the cantilever section forming process.

For producing the power generating device **1** having the device substrate **10** and the power generating section **20,** processes until finishing the cantilever section forming process are performed in units of a wafer, and a dicing process is then performed to divide the wafer into individual power generating devices **1.**

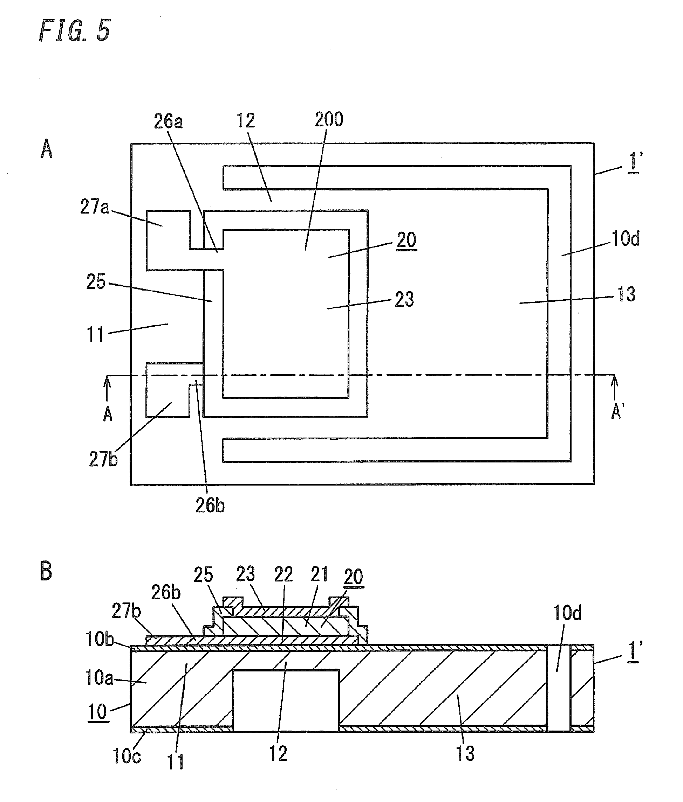

Incidentally, inventors of the present application have produced experimentally a power generating device **1'** of a first reference aspect (see Figs. 5A, 5B), before developing the power generating device **1** of the present embodiment. Like kind elements in the power generating device **1'** of the first reference aspect explained below are assigned with the same reference numerals as depicted in the power generating device **1** of the present embodiment.

The power generating device **1'** of the first reference aspect has the substantially same basic configuration with that in the first embodiment, except that: a power generating section **20** includes only one power generating element **200;** and a second pad **27b** is connected to a lower electrode **22.**

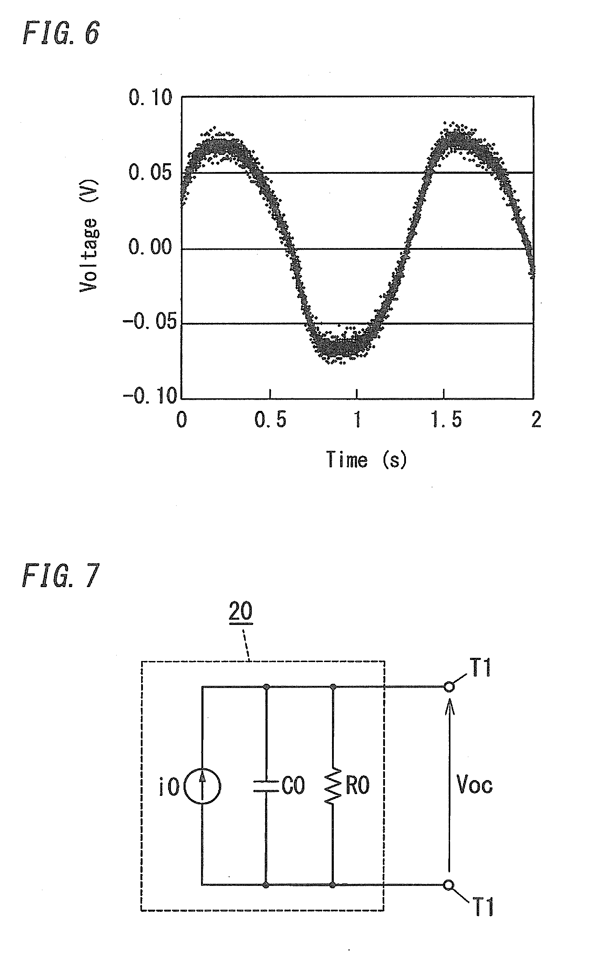

As shown in Fig. 6, open circuit voltage obtained by the power generating device **1'** of the first reference aspect has only 0.07 [V] in maximum value when the resonant frequency is set at 750 [Hz]. Note that, the power generating device **1'** outputs an AC voltage as the open circuit voltage, which is expressed by a sinusoidal wave related to the swing movement of the piezoelectric body **21.**

The inventors of the present application have learned that the power generating device **1'** of the first reference aspect with disconnecting the pads **(27a, 27b)** can be expressed by an equivalent circuit model shown in Fig. 7 and that output characteristic (open circuit voltage) of the equivalent circuit model shown in Fig. 7 is consistent with the experimental result of output characteristic (open circuit voltage) of the power generating device **1'** of the first reference aspect. In the equivalent circuit model of Fig. 7, the power generating device **1'** is expressed by a parallel circuit in which an AC power source **i0,** a capacitor **C0** that corresponds to a capacitive component of the power generating section **20,** and a resistor **R0** that corresponds to a resistor component of the power generating section **20** are connected in parallel. In a case where frequency of an external vibration conforms to the resonant frequency of the power generating device **1,** frequency of the AC power source **i0** is represented by the resonant frequency of the power generating device **1.** Incidentally, many kinks of environmental vibration such as: a vibration caused of operation of FA apparatus; a vibration caused of movement of vehicle; a vibration caused of walking of a human; or the like can be used for the power generating device **1.** The present embodiment is adapted for a vibration generated by a FA apparatus that the frequency thereof is about 475 [Hz].

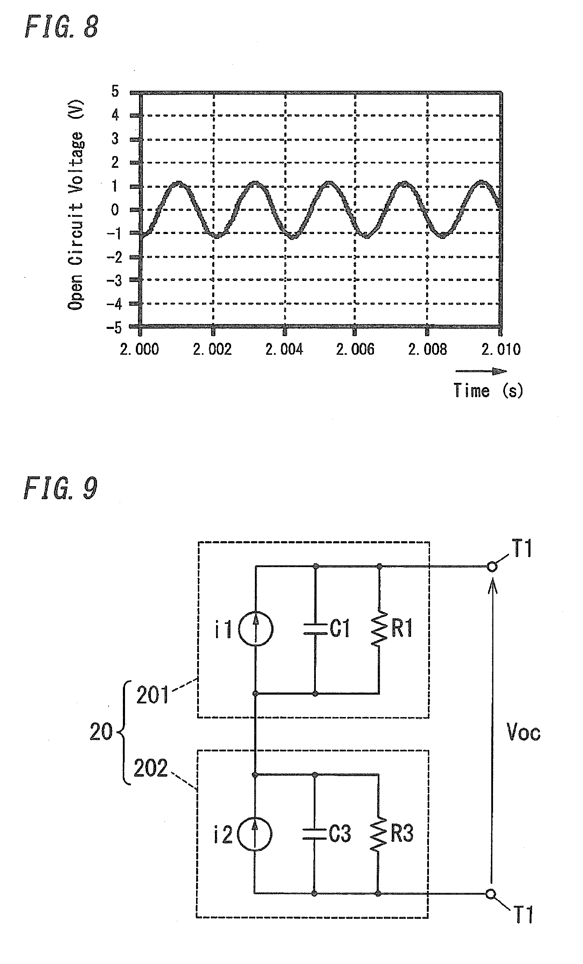

Fig. 8 shows a simulation result of a voltage waveform of the open circuit voltage **Voc** obtained by the power generating device **1'** of the first reference aspect under a condition where the resonant frequency is set at 475 [Hz]. The maximum value of the open circuit voltage **Voc** is 1.15 [V] in this case.

Fig. 9 shows an equivalent circuit model of the power generating device **1** of the present embodiment. In the equivalent circuit model of Fig. 9, the first power generating element **201** is expressed by a parallel circuit in which an AC power source **i1**, a capacitor **C1** that corresponds to a capacitive component of the first power generating section **201,** and a resistor **R1** that corresponds to a resistor component of the first power generating section **201** are connected in parallel. In this equivalent circuit model, the second power generating element **202** is expressed by a parallel circuit in which an AC power source **i2**, a capacitor **C3** that corresponds to a capacitive component of the second power generating section **202,** and a resistor **R3** that corresponds to a resistor component of the second power generating section **202** are connected in parallel. In a case where frequency of an external vibration conforms to the resonant frequency of the power generating device **1,** each frequency of the AC power sources (**i1**, **i2**) is represented by the resonant frequency of the power generating device **1.** Note that, the capacitor **C1** and the capacitor **C3** are connected in series in the power generating section **20** of the power generating device **1** of the present embodiment.

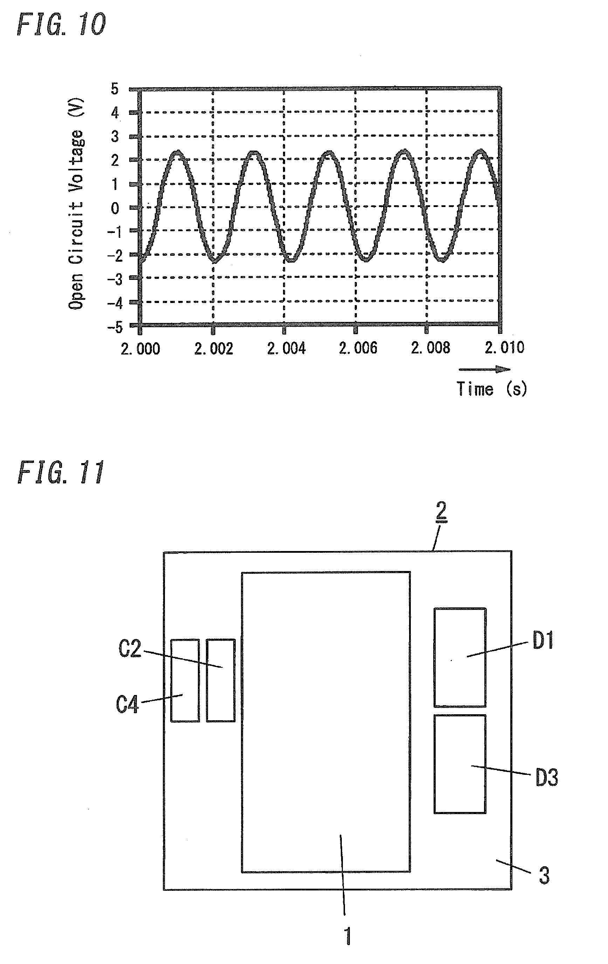

Fig. 10 shows a simulation result of an open circuit voltage **Voc** obtained by the power generating device **1** of the present embodiment. This result has been obtained under such a condition where construction parameters of the power generating device other than the power generating section **20** are set same with those in the first reference aspect according to the simulation result of Fig. 8, the thickness of the piezoelectric body **21** thereof is set same with that of the first reference aspect, and capacity of each capacitance **(C1, C3)** is set at half of that of the capacitor **C0**. The maximum value of the open circuit voltage **Voc** is 2.3 [V] in this case. According to the simulation results, the open circuit voltage **Voc** of the power generating device **1** of the present embodiment is twice as much as that of the power generating device **1'** of the first reference aspect. In this case, capacity of the power generating section **20** is obtained by a synthetic capacity of the series capacitors (**C1**, **C3),** and thus is one-fourth of that of the capacitor **C0**.

In the power generating device **1** of the present embodiment, the power generating section **20** includes: the piezoelectric body **21;** and a plurality of electrode pairs each constituted by a pair of electrodes **(22, 23)** that are placed on opposite sides of the piezoelectric body **21** with regard to a thickness direction of the piezoelectric body **21** to define the functional section **21a** therebetween, where each of the functional sections **21a** is cooperated with the related electrode pair **(22, 23)** to define the power generating element **200.** In the power generating device **1** of the present embodiment, the plurality of the power generating elements **200** include the first power generating element **201** and the second power generating element **202** that are configured to give a polarization orientation opposite to each other in the thickness direction of the piezoelectric body **21.** The first and second power generating elements **(201, 202)** are configured to have the corresponding electrodes **(22, 22)** that are connected to each other by means of the wiring member **24** on the same surface of the piezoelectric body **21** with regard to the thickness direction thereof, such that all the plurality of the power generating elements **200** are connected in series. With this configuration, the power generating device **1** of the present embodiment is enabled to increase the open circuit voltage **Voc** of the power generating section **20** without changing the chip size, compared with the power generating device **1'** of the reference aspect or the conventional power generating device shown in Fig. 23. As a result, the present embodiment can provide a power generating device that can output higher power as well as downsize the device.

In the power generating device **1** of the present embodiment, the insulation layer **25,** which determines the connection area between the upper electrode **23** and the piezoelectric body **21** as well as prevents a short between the upper electrode **23** and the lower electrode **22,** is provided extendedly so as to reach the supporting section **11** at the first surface side of the device substrate **10.** In the power generating device **1,** the piezoelectric body **21** is located inside of the peripheral line of the first metal layer **22a** in planar view and the upper electrodes **(23, 23)** are located inside of the peripheral line of the piezoelectric body **21** in planar view. This configuration enables to reduce a difference in height of a foundation on which the metal wirings (**26a**, **26b)** are formed, compared with a case where the lower electrodes **22**, the piezoelectric body **21** and the upper electrodes **23** have an identical size in planar view. The power generating device **1** of the present embodiment therefore can suppress a possibility of breaking the metal wiring (**26a**, **26b**). As a result, this configuration can improve the production yield and can improve the reliability of the product. As described in the above production process, the piezoelectric body **21** of the power generating device 1 of the present embodiment can be produced by steps of: firstly forming the first metal layer **22a** over the entire surface of the first surface side of the substrate **10a**; then forming the first metal film **21 b** that serves as a basis of the piezoelectric body **21** over the entire surface of the first surface side of the substrate **10a**; and then patterning the piezoelectric film **21 b** to form the piezoelectric body **21** formed of a part of the piezoelectric film **21** b. The power generating device **1** of the present embodiment therefore can improve the crystallinity of the piezoelectric body **21** and improve the power generating efficiency, compared with a case where the piezoelectric body **21** is produced by steps of: forming the lower electrodes **22** having desired shapes and the wiring member **24** having a desired shape at the first surface side of the substrate **10a**; then forming the piezoelectric film **21b;** and then patterning the piezoelectric film **21 b** to form the piezoelectric body **21 .**

Instead of the configuration shown in Fig. 1, such a configuration can be adopted in which the upper electrode **231** of the first power generating element **201** and the upper electrode **232** of the second power generating element **202** is connected by a wiring member, the lower electrode **221** of the first power generating element **201** is connected to the first pad **27a** through the first metal wiring **26a**, and the lower electrode **222** of the second power generating element **202** is connected to the second pad **27b** through the second metal wiring **26b.** With this configuration, the lower electrode **221** of the first power generating element **201** and the lower electrode **222** of the second power generating element **202** are not connected by the wiring member. Also in this case, the first pad **27a** is connected to an electrode (the lower electrode **221** of the first power generating element **201)** located at one end of a series circuit composed of all the power generating elements **200,** and the second pad **27b** is connected to an electrode (the lower electrode **222** of the second power generating element **202)** located at the other end of the series circuit. In this configuration, the metal wirings (**26a**, **26b),** the pads **(27a, 27b**) and the lower electrodes **(221, 222)** can be all formed simultaneously using a same material.

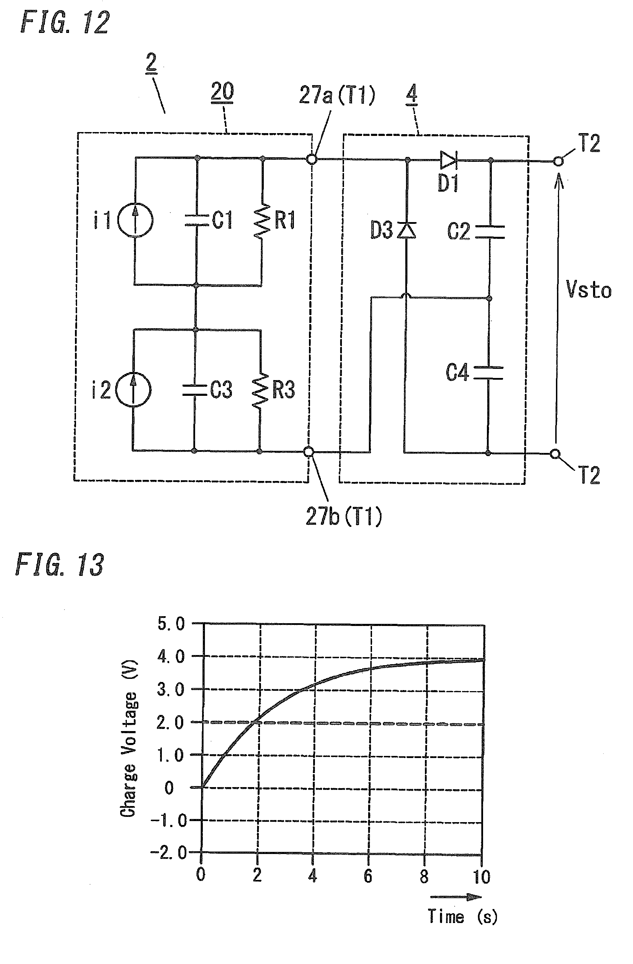

A power generating module **2** including the power generating device **1** is then described with reference to Figs. 11, 12.

The power generating module **2** includes the power generating device **1** and a circuit board 3 on which the power generating device **1** is mounted. The circuit board **3** is provided with a full-wave voltage doubler **4** (see Fig. 12) for a voltage doubler rectification of the voltage output from the power generation device **1.** The circuit board **3** is formed of a printed board. The circuit board **3** is penetratingly formed with an opening (not shown in figures) in a thickness direction of the circuit board **3** in order to form a displacement space for the movable section (defined by the cantilever section **12** and the weight section **13)** of the power generating device **1.** Note that, the circuit board **3** may be formed with a depression in order to form the displacement space, instead of the opening.

The full-wave voltage doubler **4** includes a parallel circuit in which a series circuit of two diodes **(D1, D3)** and a series circuit of two capacitors **(C2, C4)** are connected in parallel. That is, the full-wave rectifier includes the two diodes (**D1**, **D3)** and the two capacitors **(C2, C4)** that are connected to form a bridge circuit. In the power generating module **2,** the first pad **27a** of the power generating device **1** is connected to a connection point of the two diodes **(D1, D3),** and the second pad **27b** of the power generating device **1** is connected to a connection point of the capacitors **(C2, C4).** Each of the diodes (**D1**, **D3)** is a surface mount type diode. Further, each of the capacitors **(C2, C4)** is a surface mount type capacitor. With this configuration, the power generating module **2** has smaller thickness compared with a case where the diodes (**D1**, **D3)** and the capacitor **(C2, C4)** are formed of leaded chips that are connected to the circuit board 3 with inserting the lead thereof into a through hole of the circuit board **3.**

The power generating module **2** serves as a power source for a load (not shown in figures) when the load is connected between one of the output terminals **T2** that is connected to a high voltage end of the series circuit of the capacitors **(C2, C4)** and the other of the output terminals **T2** that is connected to a low voltage end of the series circuit (i.e. between both ends of the series circuit of the capacitors **(C2, C4)).** An LED (light emitting diode), a sensor or the like can be used as the load. Note that, operation voltage of LED is basically determined by a band-gap energy of crystalline material of a light emitting layer thereof. For example, an operation voltage of a red LED having a band-gap energy of 2 [eV] is about 2 [V].

The diode **D1** and the diode **D3** have a same specification with each other, and have same characteristics. Each of the diodes (**D1**, **D3)** is a silicon diode, and has a forward voltage of about 0.6 to 0.7 [V].

The capacitor **C2** and the capacitor **C4** have a same specification with each other, and have same characteristics. Each of the capacitors **(C2, C4)** has a capacity of 10 [µ F], but the capacity thereof is merely an example and is not limited thereto.

Operation of the power generating module **2** is described below briefly.

In a positive-half cycle of an output voltage in which electric potential of the first pad **27a** is higher than that of the second pad **27b,** an electric current flows from the first pad **27a** to the second pad **27b** via the diode **D1** and the capacitor **C2,** thereby charging up the capacitor **C2.** In a negative-half cycle of the output voltage in which electric potential of the first pad **27a** is lower than that of the second pad **27b,** an electric current flows from the second pad **27b** to the first pad **27a** via the capacitor **C4** and the diode **D3,** thereby charging up the capacitor **C4.** In the full-wave voltage doubler **4** of the power generating module **2,** the capacitors **(C2, C4)** are charged up alternately with each half cycle of the output voltage of the power generating device 1. Output voltage of the power generating module **2** is substantially a twice of the peak of the output voltage of the power generating device **1**. Fig. 13 shows a simulation result of change of a charge voltage **Vsto** of the series circuit of the capacitors **(C2, C4)** under a condition where voltages of the capacitors **(C2, C4)** are set "0" in start time and the frequency of the applied external vibration conforms to the resonant frequency of the power generating device **1**.

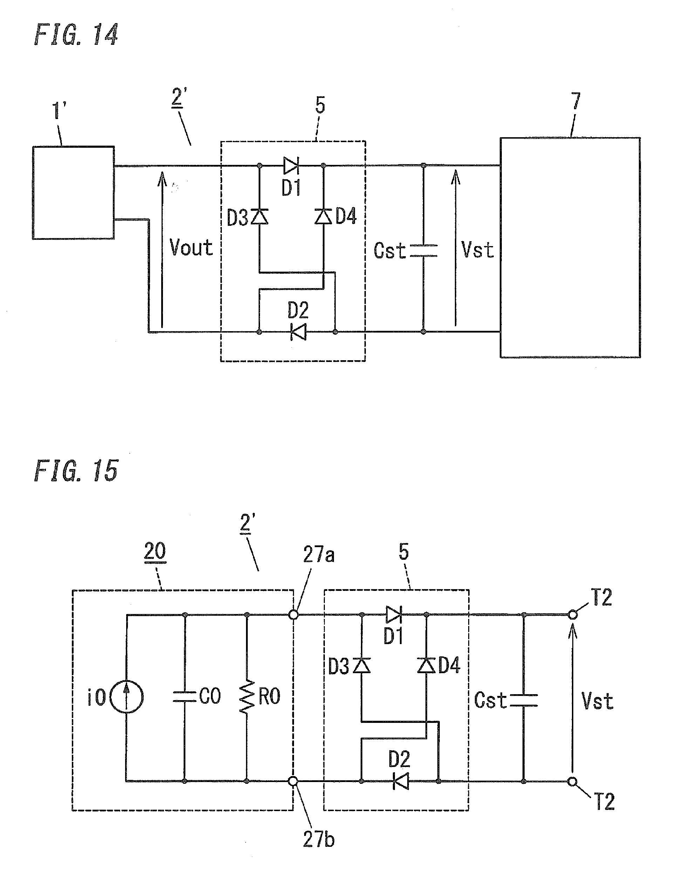

Incidentally, the inventors of the present application have produced experimentally a power generating module **2'** of a second reference aspect (see Fig. 14), before developing the power generating module **2** of the present embodiment.

The power generating module **2'** of the second reference aspect includes the power generating device **1'** of the first reference aspect, a full-wave rectifier circuit **5** connected between the first pad **27a** and the second pad **27b,** and an electric storage capacitor **Cst** connected between output terminals of the full-wave rectifier circuit **5.** Fig. 15 shows an equivalent circuit model of the power generating module **2'.** The full-wave rectifier circuit **5** is a diode bridge that includes four diodes **(D1, D2, D3, D4)** connected to form a bridge circuit. The full-wave rectifier circuit **5** is adapted to make a full-wave rectification of an output voltage **Vout** (see Fig. 14) of the power generating device **1'.** Code **"7"** shown in Fig. 14 represents a load that is connected between the both terminals of the electric storage capacitor **Cst.**

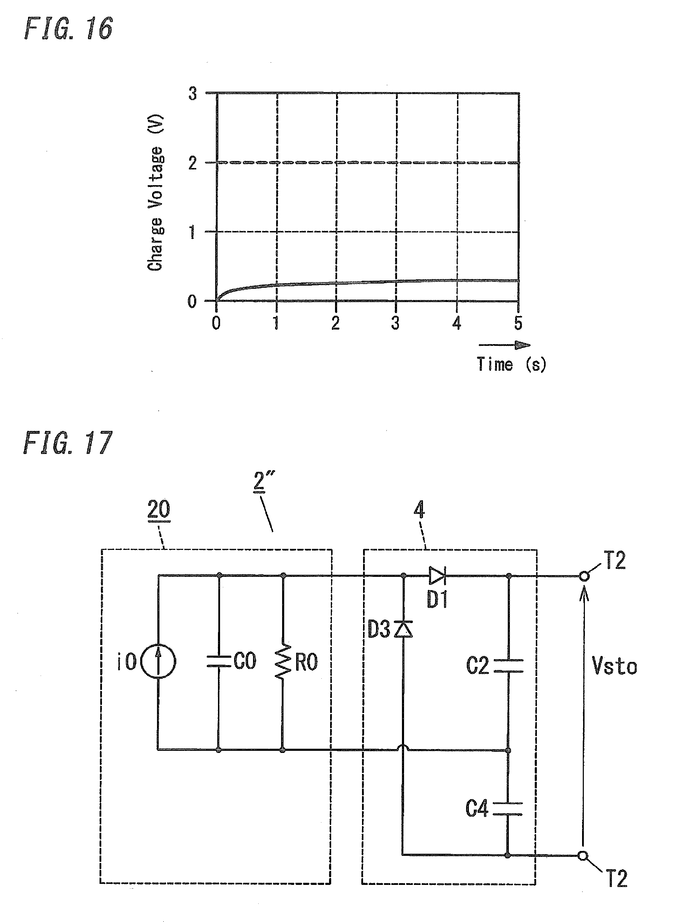

Fig. 16 shows a simulation result of change of a charge voltage **Vst** (see Fig. 15) charged in the capacitor **Cst** of the power generating module **2'** of the second reference aspect under a condition where voltage of the capacitor **Cst** is set "0" in start time, the power generating device **1'** has a resonant frequency of 200 [Hz] and the frequency of the applied external vibration conforms to the resonant frequency. As is seen from Fig. 16, the charge voltage **Vst** is saturated at about 0.3 [V]. It is thought to be due to that voltage loss (forward voltage drop) occurs at the two diodes (**D1**, **D2)** during the positive-half cycle of the output voltage in which the electric potential of the first pad **27a** is higher than that of the second pad **27b,** and that voltage loss (forward voltage drop) occurs at the two diodes **(D3, D4)** during the negative-half cycle of the output voltage in which the electric potential of the first pad **27a** is lower than that of the second pad **27b.** Therefore, the power generating module **2'** cannot light the load **7** of an LED having the operation voltage of 2 [V].

In consideration of this problem, the inventors of the present application have produced experimentally a power generating module **2"** of a third reference aspect the equivalent circuit model of which is shown in Fig. 17. The power generating module **2"** of the third reference aspect includes the full-wave voltage doubler **4** arranged in the power generating module **2** of the present embodiment, instead of the full-wave rectifier circuit **5** of the power generating module **2'** of the second reference aspect.

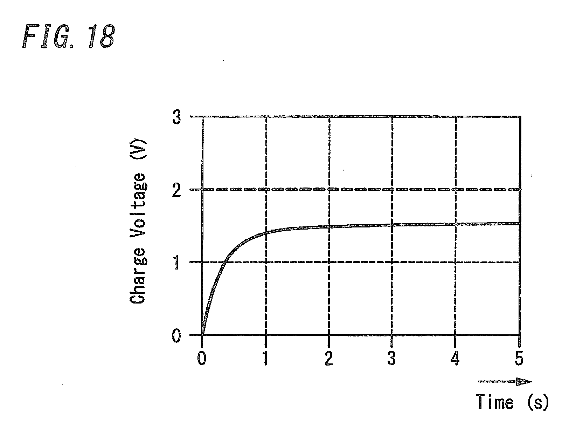

Fig. 18 shows a simulation result of change of a charge voltage **Vsto** charged in the series circuit of the capacitors **(C2, C4)** of the power generating module **2"** of the third reference aspect under a condition where voltages of the capacitors **(C2, C4)** are set "0" in start time, the power generating device **1'** has a resonant frequency of 200 [Hz] and the frequency of the applied external vibration conforms to the resonant frequency. As is seen from Fig. 18, the charge voltage **Vsto** is saturated at about 1.5 [V]. Therefore the power generating module **2"** cannot light the load **7** of an LED having the operation voltage of 2 [V].

Unlike the second and third reference aspects, the power generating module **2** of the present embodiment is enabled to have larger charge voltage **Vsto,** as is seen from the charge characteristic shown in Fig. 13. The power generating module **2** is therefore enabled to output higher power as well as downsize the device. As described abode, the power generating module **2** is enabled to light an LED having the operation voltage of 2 [V].

### (Second Embodiment)

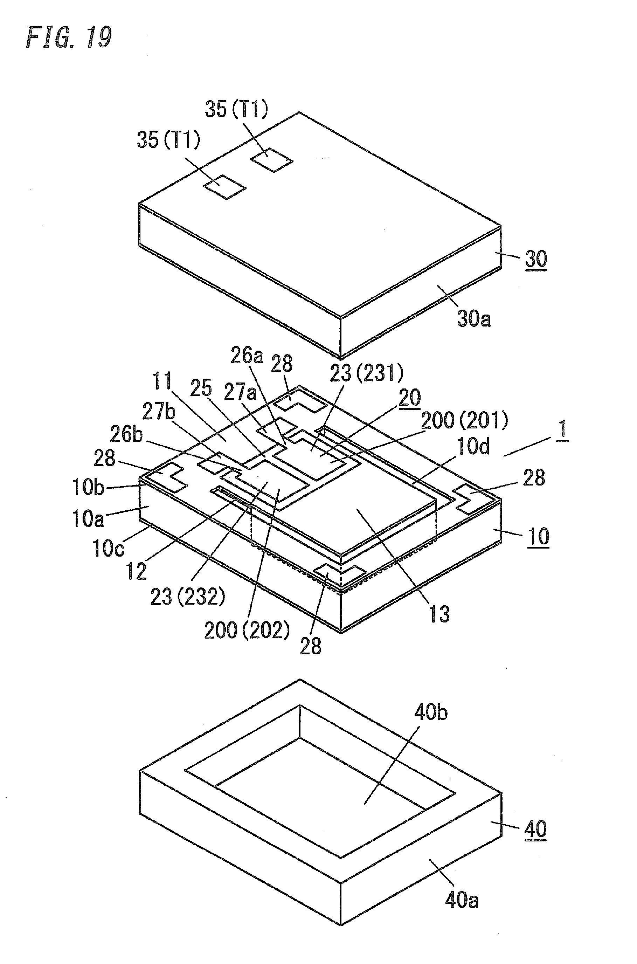

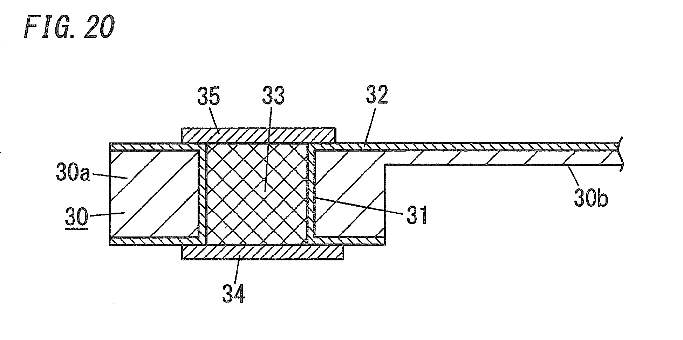

A power generating device **1** according to the present embodiment is described below with reference to Figs. 19, 20.

The power generating device **1** of the present embodiment has a similar basic configuration with that of the first embodiment, and differs from the first embodiment in that the present embodiment further includes a first cover substrate **30** fixed to a supporting section **11** at a first surface side (upper side in Fig. 19) of a device substrate **10** and a second cover substrate **40** fixed to the supporting section **11** at a second surface side (lower side in Fig. 19) of the device substrate **10** etc., in addition to the device substrate **10** formed of a substrate **10a** (hereinafter referred to as "first substrate **10a")** and a power generating section **20.** Like kind elements are assigned with the same reference numerals as depicted in the power generating device **1.**

The power generating device **1** of the present embodiment includes: the first cover substrate **30** that is fixed to the supporting section **11** at the first surface side of the device substrate **10** and covers at least the power generating section **20;** and the second cover substrate **40** that is fixed to the supporting section **11** at the second surface side of the device substrate **10.**

The first cover substrate **30** is formed of a second substrate **30a**. The second substrate **30a** is a silicon substrate. The first cover substrate **30** is formed at one surface thereof (at side of the device substrate **10;** lower side in Fig. 19) with a depression **30b** (see Fig. 20) in order to form a displacement space for a movable section (defined by a cantilever section **12** and a weight section **13**) between the first cover substrate **30** and the device substrate **10.**

The first cover substrate **30** is formed with a pair of through holes **(31, 31)** so as to penetrate in a thickness direction of the first cover substrate **30.** Each of the through holes **31** is provided with a through hole wiring **33.** The first cover substrate **30** is provided with a pair of connection electrodes **(34, 34)** at the above mentioned one surface side (lower side in Fig. 19; side of the device substrate **10**) of the first cover substrate **30.** The first cover substrate 30 is provided with a pair of output electrodes **(35, 35)** at the other surface side (upper side in Fig. 19; side opposite to the device substrate **10**) of the first cover substrate **30.** The pair of output electrodes **(35, 35)** are adapted to output an AC voltage generated by the power generating section **20.** In the power generating device **1** of the present embodiment, the pair of output electrodes **(35, 35)** serve as a pair of output terminals (**T1**, **T1**), as substitute for the pair of pads (**27a**, **27a**). As shown in Fig. 20, in the first cover substrate **30,** the connection electrodes **(34, 34)** formed on the abovementioned one surface (lower side in Fig. 19) of the first cover substrate **30** are electrically connected to respective output electrodes **(35, 35)** via the through hole wirings **(33, 33)** provided penetratingly in the thickness direction of the first cover substrate **30.** In the first cover substrate **30,** one connection electrode **34** is bonded to the first pad **27a** of the device substrate **10** to be electrically connected thereto, and the other connection electrode **34** is bonded to the second pad **27b** of the device substrate **10** to be electrically connected thereto. In the present embodiment, the output terminals **(35, 35)** and the connection electrodes **(34, 34)** each is made of a laminate of a Ti film and an Au film, but the material thereof is not limited thereto. Each of the through hole wirings **(33, 33)** is made of Cu, but the material of the through hole wiring **33** is not limited thereto. For example, Ni, Al or the like can be used for the through hole wiring **33.**

The first cover substrate **30** is further provided with an insulation film **32** of silicon dioxide film that extends across the abovementioned one surface (lower surface in Fig. 19) of the first cover substrate **30,** inner surface of the through holes **(31, 31)** inside which the through hole wirings **(33, 33)** are formed, and the abovementioned the other surface (upper surface in Fig. 19) of the first cover substrate **30,** in order to prevent a short between the two output terminals **(35, 35).** The first cover substrate **30** is not limited to a silicon substrate, and may be an insulation substrate such as a glass substrate. In this case, the insulation film **32** can be omitted. It is preferred that the glass substrate is made of such a glass material that has small difference in linear expansion coefficient from Si, such as borosilicate glass. The first cover substrate **30** may be configured such that the pads (**27a**, **27b)** formed on the first surface of the device substrate **10** are directly exposed therethrough, instead of providing the connection electrodes **(34, 34),** the through hole wirings **(33, 33)** and the output electrodes **(35, 35).** In this configuration, the first pad **27a** and the second pad **27b** serve as respective output terminals (**T1**, **T1**) as similar with the first embodiment.

The second cover substrate **40** is formed of a third substrate **40a**. The third substrate **40a** is a silicon substrate. The second cover substrate **40** is formed at one surface thereof (at side of the device substrate **10;** upper side in Fig. 19) with a depression **40b** in order to form a displacement space for the movable section between the second cover substrate **40** and the device substrate **10.** The third cover substrate **40a** is not limited to a silicon substrate, and may be an insulation substrate such as a glass substrate. It is preferred that the glass substrate is made of such a glass material that has small difference in linear expansion coefficient from Si, such as borosilicate glass.

The device substrate **10** is provided at the first surface side (upper side in Fig. 19) of the first substrate **10a** with a first bond metal layer **28** that is adapted to be bonded to the first cover substrate **30.** The first cover substrate **30** is provided at a surface of the device substrate **10** side thereof (lower side in Fig. 19) with a second bond metal layer (not shown in figures) that is adapted to be bonded to the first bond metal layer **28.** The first bond metal layer **28** is made of the same material with that of the pads (**27a**, **27b).** The first bond metal layer **28** is formed at the first surface side of the first substrate **10a** and has the same thickness with those of the pads (**27a**, **27b).**

Each cover substrate **(30, 40)** is bonded to the device substrate **10** through room temperature bonding method in this embodiment, but bonding method is not limited thereto. For example, it can adopt such as: direct bonding method that bonds them with applying a proper pressure under a higher temperature (such as 50 °C to 100 °C) than a room temperature; resin bonding method using such as epoxy resin; anodic bonding method; or the like. In the resin bonding method, it is more preferred to utilize a room temperature curing type resin adhesive (such as two-component room temperature curing type epoxy resin adhesive or one-component room temperature curing type epoxy resin adhesive) than a case where using a thermosetting type resin adhesive (such as thermosetting type epoxy resin adhesive), because the room temperature curing type resin adhesive can reduce a bonding temperature.

The power generating device **1** of the present embodiment can output higher power as well as downsize the device, as similar with the first embodiment. In the power generating device **1** of the present embodiment, it is preferred to form the first bond metal layer **28** over an entire circumference of the frame-shaped supporting section **11** and form the second bond metal layer over an entire circumference of the periphery of the first cover substrate **30.** By bonding the first bond metal layer **28** to the second bond metal layer at the entire circumference and bonding the device substrate **10** to the second cover substrate **40** at the entire circumference, an interior space surrounded by the device substrate **10** and the cover substrates **(30, 40)** is airtightly sealed. The airtight space may be maintained in an inert-gas atmosphere or a vacuum atmosphere.

The power generating device **1** of the present embodiment can be applied in the power generating module **2** of the first embodiment (see Figs. 11, 12), as substitute for the power generating device **1** of the first embodiment. This configuration also can output higher power as well as downsize the power generating module **2.** Further, the opening and the depression can be omitted from the circuit board **3** by this configuration (see Fig. 11).

### (Third Embodiment)

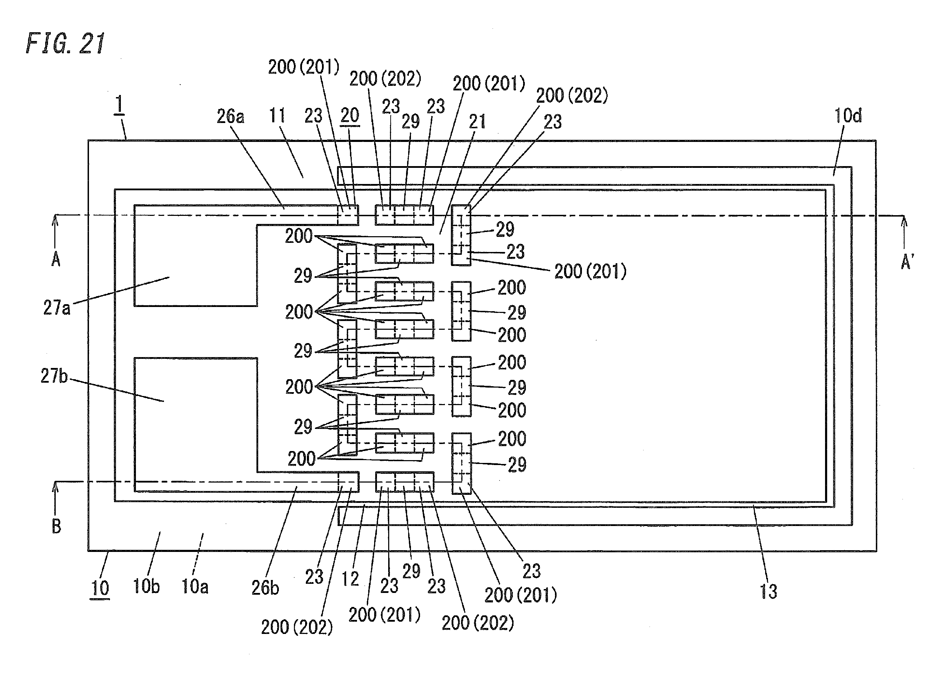

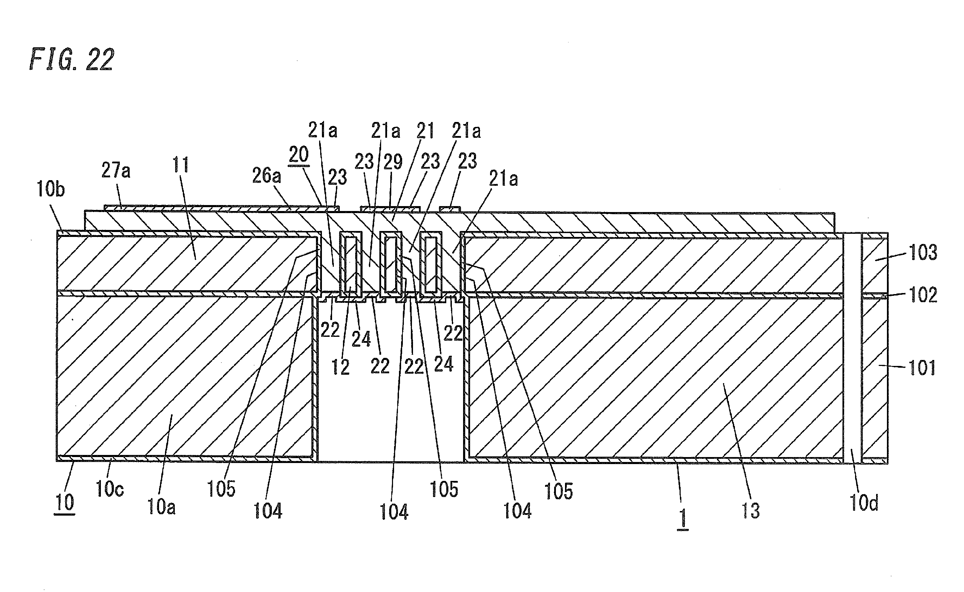

A power generating device according to the present embodiment is described below with reference to Figs. 21, 22.

The power generating device **1** of the present embodiment has a similar basic configuration with that of the first embodiment, and differs from the first embodiment in that the present embodiment utilizes, as a substrate **10a**, a SOI substrate that includes support substrate **101** of a single-crystalline silicon substrate, an insulation layer (buried oxide layer) **102** of a silicon dioxide film formed on the support substrate **101,** and a single-crystalline silicon layer **103** formed on the insulation layer **102.** Like kind elements are assigned with the same reference numerals as depicted in the power generating device **1.**

The first embodiment exemplifies such the power generating section **20** including two power generating elements **200,** as shown in Fig. 1. Compared to this, the present embodiment includes more of the power generating elements **200.** An example shown in Fig. 21 includes thirty-two power generating elements **200** along an A-B line of Fig. 21. In the figure, the power generating element **200** connected to the first pad **27a** through the first metal wiring **26a** is a first power generating element **201,** and the power generating element **200** connected to the second pad **27b** through the second metal wiring **26b** is a second power generating element **202,** and the first and second power generating elements **(201, 202)** are arranged alternately along the A-B line. The corresponding lower electrodes **(22, 22)** are connected to each other by means of a wiring member (lower wiring member) **24,** and the corresponding upper electrodes **(23, 23)** are connected to each other by means of a wiring member (upper wiring member) **29.** The electrodes **23** and the wiring member **29** are all formed simultaneously. In short, the wiring member **29** is made of the same material with those of the electrodes **(23, 23),** and is formed in the same thickness with that of the electrodes **(23, 23).**

In the device substrate **10,** a cantilever section **12** has a plurality (thirty-two in this embodiment) of embedding holes **104** that are buried to form a part of the respective functional sections **21a** of the power generating elements **200,** and the piezoelectric body **21** is formed of a self planarization film.

The self planarization film is defined as a film that is formed on an object having an irregularity under a condition where the outermost surface of the film becomes flat. In the present embodiment, the self planarization film of the piezoelectric body **21** is formed through CVD method. This configuration enables to omit a smoothing process through such as etchback method or CMP (Chemical mechanical polishing) method after forming the self planarization film.

The embedding hole **104** is formed to penetrate the cantilever section **12** in a thickness direction of the cantilever section **12.** Each of the embedding holes **104** is provided at the inner surface thereof with an insulation film **105** of a silicon dioxide film. The insulation film **105** lies between the inner surface of the embedding holes **104** and the functional section **21a**.

Producing process of the power generating section **20** of the power generating device **1** of the present embodiment is described below. Firstly, the substrate **10a** of the SOI substrate is etched from the first surface side of the substrate **10a** (from the upper side in Fig. 22) to remove a part corresponding to the embedding holes **104** up to reaching the insulation layer **102** (note that, the insulation layer **102** is not removed in this process). The substrate **10a** is then etched from the second surface side of the substrate **10a** (from the lower side in Fig. 22) to remove a part corresponding to the cantilever section **12** up to reaching the insulation layer **102** (note that, the insulation layer **102** is not removed in this process). The insulation film **105** is then formed through thermal oxidation method or the like. The piezoelectric body **21** is then formed through CVD method. The insulation layer **102** is then etched from the second surface side of the substrate **10a** to remove a part corresponding to the electrodes **22.** The electrodes **22** and the wiring members **24** are then formed. The electrodes **23** and the wiring members **29** are then formed.

It takes a long time for forming the piezoelectric body **21** of the first embodiment having a substantially uniform film thickness or forming a thick piezoelectric body **321** of the conventional example having a substantially uniform film thickness, and it leads increasing cost.

Compared to this, the power generating device **1** of the present embodiment includes the piezoelectric body **21** of the self planarization film. This configuration enables to form the functional section **21a** having a thicker thickness than that of other part of the piezoelectric body **21.** This configuration enables to increase the thickness of the functional section **21a** as well as to shorten the formation time. Therefore, this configuration enables to reduce the volume of the power generating element **200.**

The power generating device **1** of the present embodiment can output higher power as well as downsize the device, as similar with the first embodiment. The power generating device **1** of the present embodiment may be further provided with the first cover substrate **30** and the second cover substrate **40** as similar with the second embodiment.

The power generating device **1** of the present embodiment can be applied in the power generating module **2** of the first embodiment (see Fig. 11), as substitute for the power generating device **1** of the first embodiment. This configuration also can output higher power as well as downsize the power generating module **2.**

Although the present invention has been described with reference to certain preferred embodiments, numerous modifications and variations can be made by those skilled in the art without departing from the true spirit and scope of this invention, namely claims.

## Claims

1. A power generating device comprising:
a device substrate having a supporting section, a cantilever section swingably supported to said supporting section, and a weight section provided at one end of said cantilever section away from the other end supported to said supporting section; and
a power generating section carried by said cantilever section and configured to generate an AC voltage in response to a swing movement of said cantilever section,
wherein said power generating section comprises:
a piezoelectric body; and
a plurality of electrode pairs each constituted by a pair of electrodes that are placed on opposite sides of said piezoelectric body with regard to a thickness direction of said piezoelectric body to define a functional section therebetween, each of the functional sections being cooperated with the related electrode pair to define a power generating element;
wherein a plurality of the power generating elements comprises a first power generating element and a second power generating element configured to give a polarization orientation opposite to each other in the thickness direction, and
wherein said first and second power generating elements are configured to have the corresponding electrodes being connected to each other by means of a wiring member on the same surface of said piezoelectric body with regard to the thickness direction thereof, such that all of said plurality of the power generating elements are connected in series.

2. The power generating device as set forth in claim 1, wherein one electrode, which is formed on said piezoelectric body after forming said piezoelectric body, of the electrode pair is made of a sheet electrode.

3. The power generating device as set forth in claim 1,
wherein said cantilever section has embedding holes that are buried to form a part of the respective functional sections of the power generating elements, and
wherein the piezoelectric body is formed of a self planarization film.

4. The power generating device as set forth in claim 1, wherein all of said plurality of the power generating elements are connected in series such that said first and second power generating elements are connected alternately.

5. The power generating device as set forth in claim 4, wherein said corresponding electrodes of said first and second power generating elements connected to each other by means of said wiring member are formed on the same surface side in the thickness direction.

6. The power generating device as set forth in claim 1, wherein the functional sections of said plurality of the power generating elements are formed in a single piezoelectric body.

7. A power generating module comprising:
said power generating device as set forth in any one claims of 1 to 6; and
a circuit board on which said power generating device is mounted,
wherein said circuit board is provided with a full-wave voltage doubler for a voltage doubler rectification of the voltage output from said power generation device.
